# EUROPÄISCHE PATENTSCHRIFT

(11) **EP 1 184 870 B1**
(45) Veröffentlichungstag und Bekanntmachung des Hinweises auf die Patenterteilung: **07.06.2006**
(21) Anmeldenummer: 01116514.9
(22) Anmeldetag: 07.07.2001
(51) Int. Cl.: G11C 8/08, G11C 8/10, G11C 11/16

(54) **Elektronische Treiberschaltung für Wortleitungen einer Speichermatrix und Speichervorrichtung**
Electronic driving circuit for memory word lines and memory device
Circuit électronique de commande de lignes de mot d'une mémoire et dispositif de mémoire

(30) Priorität: 09.08.2000 DE 10038925
(43) Veröffentlichungstag der Anmeldung: 06.03.2002
(73) Patentinhaber: Infineon Technologies AG, 81669 München (DE)
(72) Erfinder: Böhm, Thomas, 85604 Zorneding (DE); Röhr, Thomas, Dr., 85609 Aschheim (DE); Gogl, Dietmar, 12525 Fishkill, NY (US)
(74) Vertreter: Patentanwaltskanzlei WILHELM & BECK

(56) Entgegenhaltungen:
- US-A- 4 651 031
- PATENT ABSTRACTS OF JAPAN vol. 018, no. 216 (P-1728), 18. April 1994 (1994-04-18) & JP 06 012875 A (HITACHI LTD;OTHERS: 01), 21. Januar 1994 (1994-01-21)
- PATENT ABSTRACTS OF JAPAN vol. 016, no. 365 (P-1397), 6. August 1992 (1992-08-06) & JP 04 112217 A (NEC IC MICROCOMPUT SYST LTD), 14. April 1992 (1992-04-14)

## Beschreibung

Die Erfindung betrifft eine elektronische Treiberschaltung für Wortleitungen einer Speichermatrix sowie eine Speichervorrichtung, insbesondere eine MRAM-Speichervorrichtung.

Halbleiterspeicher bestehen üblicherweise aus einem Zellenfeld mit einer Matrix von Spalten- und Zeilenleitungen, den Wort- und Bitleitungen, an deren Schnittpunkten sich die jeweilige Speicherzelle befindet. Dabei dient die Wortleitung in einem Speicherbauelement der Adressierung bei Lese- und Schreibvorgängen, die Bitleitung dem Lesen bzw. dem Beschreiben der Speicherzelle.

Als Speicherelemente bei einer MRAM-Speicherzelle werden typischerweise magnetische Tunnelelemente (TMR-Elemente; TMR: Tunnelmagnetwiderstand; engl.: tunneling magneto resistance) verwendet. Ein solches TMR-Element besteht im Prinzip aus zwei Magnetschichten, einer hartmagnetischen und einer weichmagnetischen Schicht. Diese sind durch eine isolierende Zwischenschicht mit einer Dicke von nur wenigen Atomlagen voneinander getrennt. Die Magnetisierungen in den beiden Schichten können sowohl gleichgerichtet als auch gegeneinander gerichtet sein. Die isolierende Barriere zwischen den Magnetschichten ist so dünn, dass nach Anlegen einer Spannung einige Elektronen hindurch gelangen können;es fließt ein sogenannter Tunnelstrom. Die Stärke des Tunnelstroms hängt dabei von der Orientierung der Magnetisierungsrichtungen zueinander ab.

Beschrieben wird ein solcher Speicher, indem man durch Anlegen eines elektrischen Stroms an Wortleitung und Bitleitung die Magnetisierungsrichtung der sogenannten "weichen" Magnetschicht festlegt. Durch die Richtung der Ströme wird der Inhalt des Speicherelements bestimmt. Die benötigten Ströme sind besonders beim Schreiben relativ hoch (ca. 2,5mA), da die Magnetisierung durch die Überlagerung der Magnetfelder der Ströme in der Wortleitung und Bitleitung bewirkt wird.

Beim Lesevorgang wird an die Wortleitung der selektierten Speicherzelle eine definierte Spannung angelegt, die gegenüber der Spannung der selektierten Bitleitungen unterschiedlich sein sollte. An den senkrecht zu den Wortleitungen verlaufenden Bitleitungen kann dann - je nach Beschaffung der Auswerteschaltung an den Bitleitungen - ein Lesestrom oder eine Lesespannung ausgewertet werden, der/die je nach Inhalt der adressierten Speicherzelle verschieden ist.

Diese Ansteuerungsbedingungen erfordern, dass jede Wortleitung einer Speichermatrix bei einem MRAM-Bauelement von zum Teil sehr leistungsstarken Transistoren getrieben werden muss, die in integrierten Schaltkreisen eine größere Fläche einnehmen. Diese Transistoren sollten in der Lage sein, die hohen Schreibströme zu schalten und verschiedene Spannungspotentiale für die nicht-aktivierten und die aktivierten Wortleitungen vorzusehen. Für die extrem dicht aneinanderliegenden Wortleitungen eines MRAM-Zellenfelds wird somit ein spezielles Konzept benötigt, um den Flächen- und Verdrahtungsaufwand der Wortleitungstreiberschaltung zu minimieren.

Aus dem US Patent US 4 651 031 ist eine elektronische Treiberschaltung für Wortleitungen einer Speichermatrix gemäß des Obergriffs des Anspruchs 1 bekannt.

Es ist daher Aufgabe der Erfindung, eine Treiberschaltung für die Wortleitungen einer Speichermatrix zur Verfügung zu stellen, womit der Verdrahtungsaufwand und die Fläche der Treiberschaltung reduziert werden können und zudem ein Übersprechen beim Schreiben zwischen Wortleitungen eines Blockes reduziert ist.

Diese Aufgabe wird durch die elektronische Schaltung nach Anspruch 1, mit der Speichervorrichtung nach Anspruch 10 gelöst.

Erfindungsgemäß ist vorgesehen, dass eine solche Treiberschaltung für Wortleitungen einer Speichermatrix eine Treiberquelle, vorzugsweise eine Strom-/Spannungsquelle, mit mehreren Ausgängen und mehrere Wortleitungsschalter aufweist. Diese Wortleitungsschalter verbinden schaltbar die Ausgänge der Treiberquelle mit den Wortleitungen. Die Ausgänge der Treiberquelle weisen mehrere kodierte Ausgänge auf, die über die Wortleitungsschalter mit den Wortleitungen verbunden sind, wobei die Wortleitungsschalter über ein oder mehrere Steuersignale selektiert werden. Diese kodierten Ausgänge liefern die erforderlichen Signale zum Lesen und Schreiben von Speicherzellen an einer Wortleitung.

Das erfindungsgemäße Konzept besteht darin, dass zunächst eine Anzahl von Wortleitungen selektiert und daran die kodierten Ausgänge einer Treiberquelle angelegt werden. Die kodierten Ausgänge der Treiberquelle sind dabei durch die entsprechenden Wortleitungsschalter von den nicht selektierten Wortleitungen getrennt. Durch diese Treiberschaltung kann vermieden werden, für jede der Wortleitungen einen eigenen Leitungstreiber oder einen aufwendigen Wortleitungsschalter vorzusehen, der nach Art eines Multiplexers jeweils die zur Verfügung gestellten Signale auf die Wortleitung durchschaltet. Auf diese Weise können die Wortleitungsschalter mit geringem Schaltungs- und Verdrahtungsaufwand aufgebaut werden.

In der erfindungsgemäßen Ausführungsform ist vorgesehen, dass jeder kodierte Ausgang der Treiberquelle verschiedene Ausgangswerte annehmen kann, die jeweils einem bestimmten Betriebsmodus der Wortleitungen entsprechen. Diese Ausgänge sind so kodiert sind, dass sie die verschiedenen Ausgangswerte je nach gewünschtem Betriebsmodus der jeweiligen Wortleitung zur Verfügung stellen. Die Kodierung des jeweiligen Ausgangs, der jeweils nur auf eine der Wortleitungen durchgeschaltet ist, erfolgt entsprechend einer vorgesehenen Adressierung der jeweiligen Wortleitung und des dort vorgesehenen Betriebsmodus. Dadurch, dass die Kodierung der Wortleitungssignale bereits in der Treiberquelle vorgenommen wird, kann der Schaltungsaufwand für die Wortleitungsschalter erheblich reduziert werden.

Weiterhin ist vorgesehen, dass die Ausgänge der Treiberquelle mindestens einen weiteren Ausgang umfassen, der auf alle nicht durch das Steuersignal selektierten Wortleitungen durchgeschaltet ist. Dadurch wird erreicht, dass sich die nicht aktiven Wortleitungen auf einem festen Potential befinden und nicht durch Floaten eine unerwünschte Spannung annehmen.

zudem ist vorgesehen, dass die Schaltung mehrere Steuersignale empfängt, von denen jedes eine Anzahl der mehreren Wortleitungsschalter steuert und dass höchstens eines der Steuersignale die kodierten Ausgänge der Treiberquelle auf die jeweiligen Wortleitungen über die Wortleitungsschalter durchschaltet. Auf diese Weise liegt jeweils nur einer der kodierten Ausgänge an jeweils einer der Wortleitungen an. Dadurch kann man vorteilhaft die Anzahl der zur Verfügung gestellten Ausgänge der Treiberquelle verringern. Somit werden die Wortleitungen in mehrere Blöcke unterteilt, wobei jeder der Blöcke eine Anzahl von Wortleitungen aufweist, die der Anzahl der kodierten Ausgänge der Treiberquelle entspricht. Es ist dabei zweckmäßig, den jeweiligen Schaltungs- und Verdrahtungsaufwand, der durch die Realisierung einer Treiberquelle mit einer Anzahl von Ausgängen entsteht, und die Einsparung von Schaltungs- und Verdrahtungsaufwand bei den Wortleitungsschaltern gegeneinander abzuwägen.

Erfindungsgemäß gibt der Ausgang der Treiberquelle, der über den entsprechenden Wortleitungsschalter mit einer aktiven Wortleitung verbunden ist, zum Schreiben in die Speichermatrix einen Strom aus. Mit einem solchen Schreibstrom auf der Wortleitung lassen sich z.B. TMR-Speicherelemente in MRAMs beschreiben.

Vorzugsweise sind die Wortleitungsschalter als Transistoren ausgebildet. Dies hat den Vorteil, dass diese bei integrierten Schaltungen einfach zu realisieren sind. Bei integrierten Schaltungen ist es ferner aus technologischen Gründen zweckmäßig, MOS-Transistoren als Schaltelemente vorzusehen. Diese sind ferner verlustarm, d.h. der Steuereingang ist nahezu stromlos, so dass beim Ansteuern mehrerer solcher Steuereingänge, z.B. durch das Steuersignal, wenig Treiberleistung benötigt wird.

Vorzugsweise sind die kodierten Ausgänge der Treiberquelle mit Hilfe der ersten Transistoren und/oder mindestens eines der weiteren Ausgänge der Treiberquelle über die zweiten Transistoren mit den Wortleitungen schaltbar verbunden. Die ersten Transistoren sind dabei vorzugsweise so gewählt, dass sie bei einer Selektierung durch das Steuersignal durchschalten, und die zweiten Transistoren sind so gewählt, dass sie bei dem gleichen Steuersignal sperren. Die kodierten Ausgänge werden dann infolge der Selektierung durch das Steuersignal auf die Wortleitungen geschaltet. Die weiteren Ausgänge werden folglich an die nicht durch das Steuersignal selektierten Wortleitungen über die zweiten Transistoren an die Wortleitungen angelegt. Vorteilhaft wird hierdurch erreicht, dass je nach Selektierung entweder die kodierten Ausgänge oder die weiteren Ausgänge auf die Wortleitungen geschaltet werden, wodurch der jeweilige Betriebsmodus einer Wortleitung definiert ist.

Vorzugsweise kann vorgesehen sein, dass die ersten Transistoren N-MOS-Transistoren und die zweiten Transistoren P-MOS-Transistoren sind und mit jeweils einer Wortleitung verbunden sind, wobei die ersten und zweiten Transistoren von dem Steuersignal gesteuert werden. Dies ist vorteilhaft, da N-MOS- und P-MOS-Transistoren komplementär betrieben werden können, so dass sie mit nur einem Steuersignal angesprochen werden können.

Gemäß einer bevorzugten Ausführungsform ist weiterhin vorgesehen, dass die ersten und zweiten Transistoren N-MOS-Transistoren sind, die durch zwei Steuersignale so gesteuert werden, dass jeweils nur der erste oder nur der zweite Transistor an jeder der Wortleitungen durchgeschaltet und der jeweils andere gesperrt ist. Dies ist vorteilhaft, da N-MOS-Transistoren bei gleicher Leistung eine geringere Fläche als P-MOS-Transistoren aufweisen und Spannungspegel in anderen Bereichen schalten können.

Vorzugsweise liegt an mindestens einem der kodierten Ausgänge ein erstes Spannungspotential und an dem weiteren Ausgang der Treiberquelle ein zweites Spannungspotential an, wobei das erste und das zweite Spannungspotential etwa gleich sind. Beim Wechseln zwischen Schreib- und Lesevorgang sollte das Spannungspotential aller nicht selektierten und aller nicht aktiven Wortleitungen, d.h. Wortleitungen, die sich nicht in einem Lese- oder Schreibmodus befinden, vorzugsweise unverändert bleiben, da auch hier ein Stromfluss durch die nicht adressierten Speicherelemente möglichst vermieden werden soll.

In einer bevorzugten Ausführungsform sind vier Wortleitungen vorgesehen, die durch ein Steuersignal aktiviert werden, da dadurch die Fläche des Schaltungsaufwands für die Wortleitungen minimiert werden kann. Im allgemeinen kann die Anzahl der Wortleitungen, die durch ein Steuersignal ausgewählt werden, aber beliebig angenommen werden.

In einer bevorzugten Ausführungsform gibt der Ausgang der Treiberquelle, der über den entsprechenden Wortleitungsschalter mit einer aktiven Wortleitung verbunden ist, zum Lesen aus der Speichermatrix eine Lesespannung aus. Diese Lesespannung sollte gegenüber der Spannung an den nicht-selektierten Wortleitungen unterschiedlich sein. Dies ist notwendig, um sicherzustellen, dass nur über die aktive Wortleitung ein Strom durch die TMR-Speicherzelle fließt. Bei gleichen Spannungen würde das eventuell zu einem Stromfluss durch mehrere TMR-Elemente führen, wodurch man nicht mehr feststellen könnte, durch welche Speicherzelle der Strom fließt und man somit den Inhalt der einzelnen Speicherzelle nicht mehr lesen könnte.

Weiterhin ist eine Speichervorrichtung mit einer erfindungsgemäßen Treiberschaltung vorgesehen. Darin lässt sich der Schaltungsaufwand für die Wortleitungstreiber stark reduzieren, wodurch der Wortleitungsabstand verringert werden kann.

Diesbezüglich ist bei der Speichervorrichtung weiterhin vorgesehen, dass beide Enden der Wortleitungen jeweils mit der erfindungsgemäßen Treiberschaltung versehen sind.
Dadurch lassen sich parasitäre Stromflüsse verringern. Dabei ist jedoch darauf zu achten, dass bei Einprägen von Strömen auf die jeweilige aktive Wortleitung die Ausgangsströme der kodierten Treiberquelle an beiden Enden den gleichen Betrag, aber unterschiedliche Vorzeichen aufweisen müssen.

Die Erfindung wird im folgenden anhand der Figuren und der nachfolgenden Beschreibung näher erläutert. Es zeigen
- Fig. 1: einen vordekodierten Wortleitungsschalter mit NMOS-und PMOS-Transistoren; und
- Fig. 2: einen vordekodierten Wortleitungsschalter mit NMOS-Transistoren.

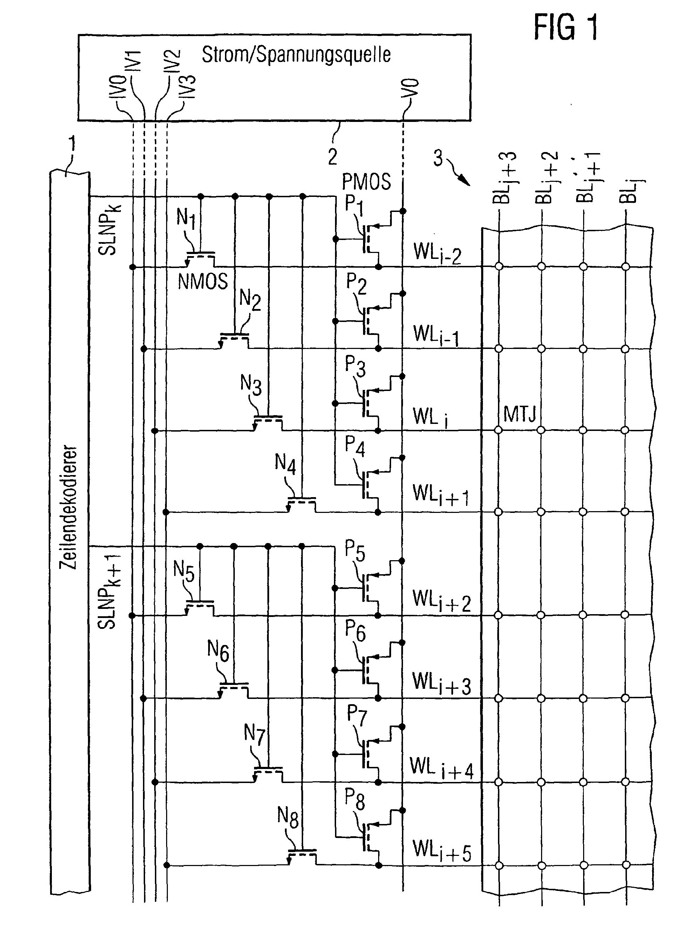

In Fig. 1 ist ein Schaltungskonzept gezeigt, in dem Blöcke von jeweils vier Wortleitungen WLᵢ₋₂-WLᵢ₊₁; WLᵢ₊₂-WLᵢ₊₅ durch jeweils ein Steuersignal SLNP eines Zeilendekodierers 1 angesteuert werden. Dieses Schaltungskonzept basiert auf der Verwendung von NMOS- und PMOS-Transistoren N₁-N₈; P₁-P₈. Die NMOS-Transistoren N₁ bis N₄ bzw. N₅ bis N₈ sind so geschaltet, dass an deren Steuereingängen (Gates) jeweils das Steuersignal SLNPₖ bzw. SLNPₖ₊₁ aus dem Zeilendekodierer 1 anliegt, wodurch die vier Ausgänge IV0-IV3 einer Strom-/Spannungsquelle 2 jeweils auf vier selektierte Wortleitungen WL durchgeschaltet werden. Je nach Kodierung der Ausgänge IV0-IV3, d.h. je nachdem, ob ein Strom- oder Spannungswert an IV0 bis IV3 anliegt, fließt ein Strom durch die Wortleitung WL bzw. liegt eine Spannung an. Die PMOS-Transistoren P₁ bis P₈ sind so geschaltet, dass sie bei einem anliegenden, nicht selektierenden Steuersignal SLNPₖ₊₁ aus dem Zeilendekodierer 1 eine Spannung V0 aus einem weiteren Ausgang V0 der Strom /Spannungsquelle 2 auf die Wortleitungen WL durchschalten. Die Anzahl der Ausgänge IV0 - IV3 ist nicht auf die Zahl vier beschränkt, sondern wird vom Fachmann je nach Anwendungsfall gewählt.

Zur Darstellung des Schaltungskonzepts wird zunächst ein Schreibvorgang auf die Wortleitung WLᵢ einer MRAM-Speichermatrix 3 betrachtet. Dazu wird über den Ausgang IV2 und den durchgeschalteten Transistor N₃ in die Wortleitung WLᵢ der Schreibstrom eingeprägt, während an allen übrigen Wortleitungen WLᵢ₋₂, WLᵢ₋₁ und WLᵢ₊₁ im wesentlichen die entsprechende Spannung aus den Ausgängen IV0, IV1, IV3 der Strom-/Spannungsquelle und an WLᵢ₊₂ bis WLᵢ₊₅ im wesentlichen die Spannung V0 anliegen. Vorzugsweise haben diese Spannungen gleiches Potential, das so gewählt ist, dass ein Stromfluss durch die angeschlossenen Speicherzellen vermieden wird. Der Zeilendekodierer 1 gibt das Steuersignal SLNPₖ, das Steuersignal SLNPₖ₊₁ und eventuell weitere Steuersignale SLNPₖ₊ₙ aus. Durch das selektierende Steuersignal SLNPₖ sind die vier NMOS-Transistoren N₁ bis N₄ eingeschaltet, und die vier NMOS-Transistoren N₅ bis N₈ an der Steuersignalleitung SLNPₖ₊₁ (und an allen weiteren SLNPₖ₊ₙ) ausgeschaltet. Mit den jeweils an beiden Steuersignalleitungen angeschlossenen vier PMOS-Transistoren P₁ bis P₄ und P₅ bis P₈ verhält es sich genau umgekehrt. Die PMOS-Transistoren P₁ bis P₄ an der Steuerleitung SLNPₖ sind gesperrt, und durch das Signal SLNPₖ₊₁ werden die Transistoren P₅ bis P₈ durchgeschaltet. Die durch das Steuersignal SLNPₖ durchgeschalteten NMOS-Transistoren N₁ bis N₄ lassen die Ströme und im wesentlichen auch die Spannungen der Stromspannungsquellen IV0 bis IV3 durch.

In dem dargestellten Beispiel wird von dem Ausgang IV2 der Strom-/Spannungsquelle 2 über den durchlässigen NMOS-Transistor N₃ der Schreibstrom in die Wortleitung WLᵢ eingeprägt. Über die Ausgänge IV0, IV1 und IV3, der Strom-/Spannungsquelle 2 werden über die NMOS-Transistoren N₁, N₂ und N₄ die jeweilige, vorzugsweise gleiche Spannungen an die nicht selektierten Wortleitungen WLᵢ₋₂, WLᵢ₋₁ und WLᵢ₊₁ angelegt. Bei den durch das Steuersignal SLNPₖ₊₁ des Zeilendekodierers 1 nicht selektierten Wortleitungsblöcken WLᵢ₊₂-WLᵢ₊₅ sind die PMOS-Transistoren P₅ bis P₈ durchgeschaltet. An den Wortleitungen WLᵢ₊₂ bis WLᵢ₊₅ liegt dann etwa die Spannung V0 an. Diese Spannung ist vorzugsweise so dimensioniert, dass sie gleich den Spannungen IV0, IV1 und IV3 ist.

Das Lesen aus dem Speicher geschieht analog. Soll ein Datenwort ausgelesen werden, das an der Adresse der Wortleitung WLᵢ gespeichert ist, so wird über IV2 nicht ein Strom, sondern eine Spannung angelegt, die sich von den übrigen Spannungen unterscheidet, wodurch die Wortleitung WLᵢ selektiert wird. Über IV0, IV1, IV3 und V0 liegen ebenfalls alle nicht adressierten Wortleitungen WLᵢ₋₂, WLᵢ₋₁, WLᵢ₊₁-WLᵢ₊₅ der Speichermatrix 3 auf einer festen Spannung. Es handelt sich dabei vorzugsweise um die gleiche Spannung, die auch beim Schreiben an den nicht adressierten Wortleitungen WL angelegen hat.

Die Strom-/Spannungsquelle mit den kodierten Ausgängen IV0 bis IV3 übernehmen also gleichzeitig das Bereitstellen der Treiberleistung und einen Teil der Adressierung, wodurch der Aufwand an Steuerleitungen SLNP vom Zeilendekodierer 1 zu den Schalttransistoren N₁ - N₈; P₁-P₈ nur ein Viertel der Wortleitungen WL der Speichermatrix 3 beträgt.

Die Strom-/Spannungsquelle 2 ist so gestaltet, dass sowohl für Lese- als auch für Schreibvorgänge die Wortleitungen WL eines Viererblocks durch die Ausgangssignale IV0 bis IV3 angesteuert werden. An den nicht adressierten Wortleitungen WLᵢ₋₂, WLᵢ₋₁, WLᵢ₊₁ liegen entsprechend an dem jeweiligen Ausgang im wesentlichen (abzüglich eines Spannungsabfalls über den jeweiligen Schalttransistor) die Spannungen IV0-IV3 an. Die Spannung V0 liegt an allen Wortleitungen WLᵢ₊₂-WLᵢ₊₅ der nicht durch das Steuersignal SLNPₖ selektierten Viererblöcke an.

Beim Schreibvorgang in eine MRAM-Speicherzelle wird eine bestimmte Wortleitung WL durch einen entsprechenden Strom an dem bestimmten Ausgang IV0 -IV3 der Strom-/Spannungsquelle 2 adressiert. Dieser Strom kann je nach zu schreibenden Speicherinhalt eine positive oder negative Flussrichtung aufweisen. Beim Lesen in einer MRAM-Speicherzelle ist das adressierende Ausgangssignal eine Spannung, die gegenüber der Spannung der nicht selektierten Wortleitungen WL verschieden ist. Diese führt zu einem Stromfluss durch die Speicherzelle auf die daran angeschlossenen Bitleitungen, wobei die Stärke des Stroms den Inhalt der Speicherzelle repräsentiert.

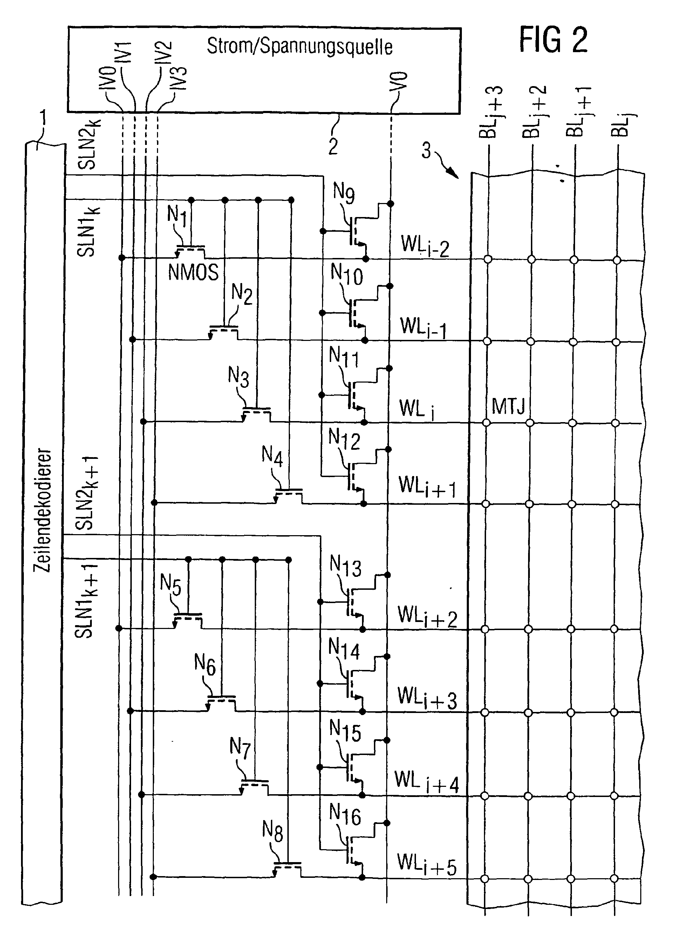

Die Wahl aus den möglichen Spannungen ist bei der Verwendung von PMOS-Transistoren gemäß dem Ausführungsbeispiel nach Fig. 1 eingeschränkt. Insbesondere das Spannungspotential von 0V lässt sich bei den Standardbetriebsbedingungen von integrierten Schaltkreisen (z.B. V_{DD}=5V, 3,3V bzw. 1,8 V bzw. V_{GND}=0V) nicht mit P-MOS-Transistoren auf die Wortleitungen WL schalten. Deshalb werden in einer weiteren Ausführungsform gemäß Fig. 2 NMOS-Transistoren anstelle der PMOS-Transistoren verwendet, da diese sich besser für das Schalten von Spannungen nahe dem Potential von 0 Volt eignen. Die Funktion ist ähnlich der Schaltung in Figur 1. Die PMOS-Schalttransistoren zum Schalten des Ausgangs V0 sind jedoch nun durch NMOS-Transistoren N₉ bis N₁₂ und N₁₃ bis N₁₆ ersetzt. Diese können jedoch aufgrund der erforderlichen Gate-Spannung nicht mehr gemeinsam über eine Leitung mit den zugehörigen NMOS-Transistoren N₁ bis N₄ und N₅ und N₈ geschaltet werden. Für jeden Viererblock werden deshalb getrennte Steuerleitungen SLN1ₖ und SLN2ₖ benötigt, wodurch der Verdrahtungsaufwand für die Steuerleitungen SLNP nur noch auf die Hälfte der Anzahl der Wortleitungen WL der Speichermatrix 3 reduziert werden kann. Dieser Nachteil wird jedoch aufgewogen, da integrierte NMOS-Transistoren bei gleicher Treiberleistung eine geringere Fläche als PMOS-Transistoren benötigen.

Die logischen Pegel SLN1ₖ und SLN2ₖ verlaufen im wesentlichen invertiert. Lediglich die Spannungspegel von SLN2ₖ sind gegenüber dem Ausführungsbeispiel der Fig. 1 so dimensioniert, dass sie ein Schalten der Spannung V0 mit Hilfe der NMOS-Transistoren N₉ bis N₁₂ bzw. N₁₃ bis N₁₆ auf die Wortleitungen WL ermöglichen.

Um den Strom in die selektierte Wortleitung WL einprägen zu können, kann es zweckmäßig sein, an beiden Enden der Wortleitungen WL eine Beschaltung gemäß dieser Erfindung einzusetzen, wobei jedoch die Strom-/Spannungsquellen 2 Ströme mit gleichem Betrag aber unterschiedlichem Vorzeichen liefern sollten. Solche gegenpolig gerichtete Stromquellen vermindern parasitäre Stromflüsse in erheblichem Maße. Auf ähnliche Weise können durch das Anlegen einer Spannung auf beiden Seiten einer Wortleitung WL die Auswirkungen von Spannungsabfällen durch parasitäre Ströme reduziert werden.

Die in der vorangehenden Beschreibung, den Ansprüchen und den Zeichnungen offenbarten Merkmale der Erfindung können sowohl einzeln als auch in beliebiger Kombination für die Verwirklichung der Erfindung in ihren verschiedenen Ausführungsformen wesentlich sein.

### Bezugszeichenliste

- 1: Zeilendekodierer
- 2: Strom-/Spannungsquelle
- 3: Speichermatrix
- N₁-N₁₆: Wortleitungsschalter; N-MOS-Transistoren
- P₁-P₈: Wortleitungsschalter; P-MOS-Transistoren
- SLNPₖ, SLN1_{K}, SLN2_{K}: Steuersignalleitungen
- WLᵢ: Wortleitungen
- IV0-IV3: Ausgänge der Strom-/Spannungsquelle
- V0: weiterer Ausgang der Strom-/Spannungsquelle

## Patentansprüche

1. Elektronische Treiberschaltung für Wortleitungen einer Speichermatrix, wobei die Treiberschaltung eine Treiberquelle (2) mit mehreren Ausgängen (IV0-IV3, V0) aufweist, wobei mehrere Wortleitungsschalter (N₁-N₁₆, P₁₋P₈) vorgesehen sind, die über ein Steuersignal (SLNP; SLN1; SLN2) ansteuerbar sind und über die die Ausgänge (IV0-IV3, V0) der Treiberquelle (2) mit den Wortleitungen (WL) schaltbar verbunden sind, wobei die mehreren Ausgänge (IV0-IV3, V0) der Treiberquelle kodierte Ausgänge (IVO-IV3) umfassen, wobei jeder kodierte Ausgang (IV0-IV3) der Treiberquelle (2) verschiedene Ausgangswerte unabhängig von den anderen kodierten Ausgängen annehmen kann, die jeweils einem bestimmten Betriebsmodus der Wortleitungen (WL) entsprechen und die so kodiert sind, dass sie die verschiedenen Ausgangswerte je nach gewünschtem Betriebsmodus der jeweiligen Wortleitung (WL) zur Verfügung stellen,
wobei die Treiberschaltung mehrere Steuersignale (SLNP; SLN1, SLN2) empfängt, von denen jedes eine Anzahl der mehreren Wortleitungsschalter (N₁..., P₁...) steuert und dass höchstens eines der Steuersignale (SLNP; SLN1; SLN2) die kodierten Ausgänge (IV0-IV3) der Treiberquelle (2) auf die jeweiligen Wortleitungen (WL) über die Wortleitungsschalter (N₁-N₁₆; P₁-P₈) durchschaltet, so dass jeweils nur einer der kodierten Ausgänge (IV0-IV3) an jeweils einer der Wortleitungen (WL) anliegt
**dadurch gekennzeichnet, dass**
die Ausgangswerte bei einem Schreibvorgang einen Stromwert und bei einem Lesevorgang einem Spannungswert entsprechen,
**dass** der Ausgang (IVO-IV3) der Treiberquelle (2), der über den entsprechenden Wortleitungsschalter (N₁-N₈) mit einer aktiven Wortleitung (WL) verbunden ist, zum Schreiben in die Speichermatrix (3) einen Strom ausgibt, dass der Ausgang (IV0-IV3) der Treiberquelle (2), der über den entsprechenden Wortleitungsschalter (N₁-N₈) mit einer aktiven Wortleitung (WL) verbunden ist, zum Lesen aus der Speichermatrix (3) eine Lesespannung ausgibt, wobei beim Schreiben mindestens eine Wortleitung eines Blockes von Wortleitungen selektiert ist, wobei in die selektierte Wortleitung ein Strom eingeprägt ist, wobei die nicht selektierten Wortleitungen des Blocks durch die Treiberschaltung auf gleicher Spannung gehalten sind.

2. Treiberschaltung nach Anspruch 1, **dadurch gekennzeichnet, dass** die Wortleitungsschalter (WL) erste (N₁ - N₈) und zweite Transistoren (N₉-N₁₆; P₁-P₈) aufweisen.

3. Treiberschaltung nach Anspruch 2, **dadurch gekennzeichnet, dass** die kodierten Ausgänge (IV0-IV3) der Treiberquelle (2) über die ersten Transistoren (N₁-N₈) mit den Wortleitungen (WL) verbunden sind.

4. Treiberschaltung nach einem der Ansprüche 2 oder 3, **dadurch gekennzeichnet, dass** mindestens einer der Ausgänge (IV0-IV3) der Treiberquelle (2) über die zweiten Transistoren (N₉-N₁₆; P₁-P₈) mit den Wortleitungen verbunden ist.

5. Treiberschaltung nach einem der Ansprüche 1 bis 3, **dadurch gekennzeichnet, dass** die ersten Transistoren (N₁₋N₈) N-MOS-Transistoren und die zweiten Transistoren (P₁₋P₈) P-MOS-Transistoren und mit jeweils einer Wortleitung verbunden sind, wobei die ersten (N₁-N₈) und die zweiten (P₁-P₈) Transistoren von dem Steuersignal (SLNP) gesteuert werden.

6. Treiberschaltung nach einem der Ansprüche 1 bis 3, **dadurch gekennzeichnet, dass** die ersten (N₁-N₈) und zweiten (N₉-N₁₆) Transistoren N-MOS-Transistoren sind, die durch zwei Steuersignale (SLN2_{K}; SLN2_{K+1}) so gesteuert werden, dass jeweils nur der erste (N₁-N₈) oder nur der zweite (N₉-N₁₆) Transistor an jeder der Wortleitungen (WL) durchgeschaltet und der jeweils andere gesperrt ist.

7. Treiberschaltung nach einem der Ansprüche 1 bis 6, **dadurch gekennzeichnet, dass** die Treiberquelle (2) eine Strom-/Spannungsquelle ist.

8. Treiberschaltung nach einem der Ansprüche 1 bis 6, **dadurch gekennzeichnet, dass** an mindestens einem der kodierten Ausgänge (IV0-IV3) ein erstes Spannungspotential und an dem weiteren Ausgang der Treiberquelle ein zweites Spannungspotential anliegen, wobei das erste und das zweite Spannungspotential etwa gleich sind.

9. Treiberschaltung nach einem der Ansprüche 1 bis 7, **dadurch gekennzeichnet, dass** die Anzahl von Wortleitungen (WL), die durch jeweils ein Steuersignal (SLNP; SLN1; SLN2) aktiviert werden, 4 beträgt.

10. Speichervorrichtung,
**dadurch gekennzeichnet, dass**
sie zwei elektronische Treiberschaltungen nach einem der vorangehenden Ansprüche aufweist, und dass beide Enden der Wortleitungen (WL) jeweils mit einer elektronischen Treiberschaltung versehen sind.

11. Speichervorrichtung nach Anspruch 10, **dadurch gekennzeichnet, dass** die Treiberquelle (2) an beiden der Wortleitungen (WL) Stromquellen aufweisen, wobei die Treiberquellen (2) so gestaltet sind, dass Ströme, die in die jeweilige aktive Wortleitung (WL) eingeprägt werden, den gleichen Betrag, aber ein unterschiedliches Vorzeichen aufweisen.

12. Nichtflüchtiger magnetischer Halbleiterspeicher, **dadurch gekennzeichnet, dass** er eine Speichervorrichtung nach einem der Ansprüche 10 oder 11 aufweist.

## Claims

1. Electronic driver circuit for word lines in a memory matrix, where the driver circuit has a driver source (2) having a plurality of outputs (IV0-IV3 V0), with a plurality of word line switches (N₁-N₁₆; P₁-P₈) being provided which can be driven by means of a control signal (SLNP; SLN1; SLN2) and by means of which the outputs (IV0-IV3, V0) of the driver source (2) are switchably connected to the word lines (WL), where
the plurality of outputs (IV0-IV3, V0) of the driver source comprise coded outputs (IV0-IV3), with each coded output (IV0-IV3) of the driver source (2) being able to assume various output values, independently of the other coded outputs, which respectively correspond to a particular operating mode of the word lines (WL) and which are coded such that they provide the various output values according to the desired operating mode of the respective word line (WL), the driver circuit receiving a plurality of control signals (SLNP; SLN1; SLN2), each of which controls a number of the plurality of word line switches (N₁, .., P₁...), and at most one of the control signals (SLNP; SLN1; SLN2) switching through the coded outputs (IV0-IV3) of the driver source (2) to the respective word lines (WL) via the word line switches (N₁-N₁₆; P₁-P₈), so that in each case only one of the coded outputs (IV0-IV3) is connected to a respective one of the word lines (WL), **characterized in that** the output values correspond to a current value in the case of a write operation and to a voltage value in the case of a read operation, **in that** that output (IV0-IV3) of the driver source (2) which is connected to an active word line (WL) by means of the appropriate word line switch (N₁-N₈) outputs a current for the purpose of writing to the memory matrix (3), **in that** that output (IV0-IV3) of the driver source (2) which is connected to an active word line (WL) by means of the appropriate word line switch (N₁₋N₈) outputs a reading voltage for the purpose of reading from the memory matrix (3), with writing involving at least one word line in a block of word lines having been selected, with a current having been impressed into the selected word line, and with the unselected word lines in the block being held at the same voltage by the driver circuit.

2. Driver circuit according to Claim 1, **characterized in that** the word line switches (WL) have first transistors (N₁-N₈) and second transistors (N₉-N₁₆; P₁-P-P₈).

3. Driver circuit according to Claim 2, **characterized in that** the coded outputs (IV0-IV3) of the driver source (2) are connected to the word lines (WL) by means of the first transistors (N₁-N₈).

4. Driver circuit according to either of Claims 2 and 3, **characterized in that** at least one of the outputs (IV0-IV3) of the driver source (2) is connected to the word lines by means of the second transistors (N₉-N₁₆; P₁-P₈).

5. Driver circuit according to one of Claims 1 to 3, **characterized in that** the first transistors (N₁-N₈) are N-MOS transistors, and the second transistors (P₁-P₈) are P-MOS transistors and are connected to a respective word line, the first transistors (N₁-N₈) and the second transistors (P₁-P₈) being controlled by the control signal (SLNP).

6. Driver circuit according to one of Claims 1 to 3, **characterized in that** the first transistors (N₁-N₈) and the second transistors (N₉-N₁₆) are N-MOS transistors which are controlled by two control signals (SLN2ₖ; SLN2ₖ₊₁) such that in each case only the first transistor (N₁-N₈) or only the second transistor (N₉-N₁₆) on each of the word lines (WL) is on, and the other one is off.

7. Driver circuit according to one of Claims 1 to 6, **characterized in that** the driver source (2) is a current/voltage source.

8. Driver circuit according to one of Claims 1 to 6, **characterized in that** a first voltage potential is present at at least one of the coded outputs (IV0-IV3), and a second voltage potential is present at the further output of the driver source, the first and second voltage potentials being approximately the same.

9. Driver circuit according to one of Claims 1 to 7, **characterized in that** the number of word lines (WL) which are activated by a respective control signal (SLNP; SLN1; SLN2) is 4.

10. Memory apparatus,
**characterized in that**
it has two electronic driver circuits according to one of the preceding claims, and **in that** the two ends of the word lines (WL) are respectively provided with an electronic driver circuit.

11. Memory apparatus according to Claim 10, **characterized in that** the driver sources (2) have current sources on both of the word lines (WL), the driver sources (2) being designed such that currents impressed into the respective active word line (WL) have the same magnitude but a different arithmetic sign.

12. Nonvolatile magnetic semiconductor memory, **characterized in that** it has a memory apparatus according to either of Claims 10 and 11.

## Revendications

1. Circuit d'attaque électronique pour des lignes de mots d'une matrice de mémoire, le circuit d'attaque comportant une source d'attaque (2) avec plusieurs sorties (IV0 à IV3, V0), plusieurs interrupteurs de lignes de mots (N₁ à N₁₆; P₁ à P₈) étant prévus, lesquels peuvent être commandés par l'intermédiaire d'un signal de commande (SLNP ; SLN1; SLN2) et par l'intermédiaire desquels les sorties (IV0 à IV3, V0) de la source d'attaque (2) sont reliées de manière à pouvoir être commutées aux lignes de mots (WL),
les plusieurs sorties (IV0 à IV3, V0) de la source d'attaque comprenant des sorties codées (IV0 à IV3), chaque sortie codée (IV0 à IV3) de la source d'attaque (2) pouvant prendre différentes valeurs de sortie indépendamment des autres sorties codées qui correspondent à chaque fois à un certain mode de fonctionnement des lignes de mots (WL) et qui sont codées de telle sorte qu'elles fournissent les différentes valeurs de sortie selon le mode de fonctionnement souhaité de la ligne de mot respective (WL),
le circuit d'attaque recevant plusieurs signaux de commande (SLNP ; SLN1, SNL2) parmi lesquels chacun commande un nombre de plusieurs interrupteurs de lignes de mots (N₁, ..., P₁, ...) et au maximum l'un des signaux de commande (SLNP ; SLN1 ; SLN2) connecte les sorties codées (IV0 à IV3) de la source d'attaque (2) sur les lignes de mots respectives (WL) par l'intermédiaire des interrupteurs de lignes de mots (N₁ à N₁₆ ; P₁ à P₈) de telle sorte que, à chaque fois, une seule des sorties codées (IV0 à IV3) se trouve sur l'une des lignes de mots (WL),
**caractérisé en ce que**
la valeur de sortie correspondent à une valeur de courant lors d'une opération d'écriture et à une valeur de tension lors d'une opération de lecture,
la sortie (IV0 à IV3) de la source d'attaque (2) qui est reliée à une ligne de mot active (WL) par l'intermédiaire de l'interrupteur de ligne de mot (N₁ à N₈) correspondant délivre un courant pour l'écriture dans la matrice de mémoire (3),
la sortie (IV0 à IV3) de la source d'attaque (2) qui est reliée à une ligne de mot active (WL) par l'intermédiaire de l'interrupteur de ligne de mot (N₁ à N₈) correspondant délivre une tension de lecture pour la lecture dans la matrice de mémoire (3),
au moins une ligne de mot d'un bloc de lignes de mots étant sélectionnée lors de l'écriture, un courant étant introduit dans la ligne de mot sélectionnée, les lignes de mots non sélectionnées du bloc étant maintenues à une tension identique par le circuit d'attaque.

2. Circuit d'attaque selon la revendication 1, **caractérisé en ce que** les interrupteurs de lignes de mots (WL) comportent des premiers transistors (N₁ à N₈) et des deuxièmes transistors (N₉ à N₁₆ ; P₁ à P₈).

3. Circuit d'attaque selon la revendication 2, **caractérisé en ce que** les sorties codées (IV0 à IV3) de la source d'attaque (2) sont reliées par l'intermédiaire des premiers transistors (N₁ à N₈) aux lignes de mots (WL).

4. Circuit d'attaque selon l'une des revendications 2 ou 3, **caractérisé en ce qu'**au moins l'une des sorties (IV0 à IV3) de la source d'attaque (2) est reliée par l'intermédiaire des deuxièmes transistors (N₉ à N₁₆ ; P₁ à P₈) aux lignes de mots.

5. Circuit d'attaque selon l'une des revendications 1 à 3, **caractérisé en ce que** les premiers transistors (N₁ à N₈) sont des transistors N-MOS et les deuxièmes transistors (P₁ à P₈) des transistors P-MOS et sont reliés à chaque fois à une ligne de mot, les premiers transistors (N₁ à N₈) et les deuxièmes transistors (P₁ à P₈) étant commandés par le signal de commande (SLNP).

6. Circuit d'attaque selon l'une des revendications 1 à 3, **caractérisé en ce que** les premiers transistors (N₁ à N₈) et les deuxièmes transistors (N₉ à N₁₆) sont des transistors N-MOS qui sont commandés par deux signaux de commande (SLN2_{K} ; SLN2_{K+1}) de telle sorte que, à chaque fois, seul le premier transistor (N₁ à N₈) ou seul le deuxième transistor (N₉ à N₁₆) est connecté sur chacune des lignes de mots (WL) et l'autre transistor respectif est bloqué.

7. Circuit d'attaque selon l'une des revendications 1 à 6, **caractérisé en ce que** la source d'attaque (2) est une source de courant / tension.

8. Circuit d'attaque selon l'une des revendications 1 à 6, **caractérisé en ce qu'**un premier potentiel de tension est appliqué à au moins l'une des sorties codées (IV0 à IV3) et un deuxième potentiel de tension à l'autre sortie de la source d'attaque, le premier et le deuxième potentiels de tension étant sensiblement égaux.

9. Circuit d'attaque selon l'une des revendications 1 à 7, **caractérisé en ce que** le nombre de lignes de mots (WL) qui sont activées à chaque fois par un signal de commande (SLNP ; SLN1 ; SLN2) vaut 4.

10. Mémoire, **caractérisée en ce qu'**elle comporte deux circuits d'attaque électroniques selon l'une des revendications précédentes, et **en ce que** les deux extrémités des lignes de mots (WL) sont munies chacune d'un circuit d'attaque électronique.

11. Mémoire selon la revendication 10, **caractérisée en ce que**, sur les deux lignes de mots (WL), la source d'attaque (2) comporte des sources de courant, les sources d'attaque (2) étant conçues de telle sorte que des courants qui sont introduits dans la ligne de mot (WL) active respective ont la même valeur absolue mais un signe différent.

12. Mémoire à semi-conducteurs, magnétique et non volatile, **caractérisée en ce qu'**elle comporte une mémoire selon l'une des revendications 10 ou 11.
